Europäisches Patentamt

European Patent Office

Office européen des brevets

(11) Publication number: **0 199 565 B1**

## EUROPEAN PATENT SPECIFICATION

(45) Date of publication of patent specification: **11.11.92**

(51) Int. Cl.⁵: **H01S 3/025**, H01S 3/133, G11B 7/12

(21) Application number: **86302954.2**

(22) Date of filing: **18.04.86**

(54) Semiconductor laser apparatus for optical heads.

(30) Priority: **22.04.85 JP 86178/85**
**22.04.85 JP 86179/85**

(43) Date of publication of application:
**29.10.86 Bulletin 86/44**

(45) Publication of the grant of the patent:
**11.11.92 Bulletin 92/46**

(84) Designated Contracting States:
**AT DE FR GB IT NL**

(56) References cited:
**EP-A- 0 029 755**
**EP-A- 0 061 384**

**PATENT ABSTRACTS OF JAPAN, vol. 5, no. 163 (E-78)[835], 20th October 1981; & JP-A-56 93 388**

**PATENT ABSTRACTS OF JAPAN, vol. 7, no. 272 (E-214)[1417], 3rd December 1983; & JP-A-58 153 388**

**AUDIO, vol. 66, no. 11, November 1982, pages 40-42, Columbus, Ohio, US; "Compact disc: optics and electronics"**

**ELECTRONIC DESIGN, vol. 26, no. 26, 20th December 1978, pages 23-24, Rochelle Park, US; S.E. SCRUPSKI: "Laser optical recorder stores billions of bits on one disc"**

(73) Proprietor: **SONY CORPORATION**
**7-35 Kitashinagawa 6-chome Shinagawa-ku Tokyo 141(JP)**

(72) Inventor: **Oinoue, Hiroshi**
**Patents Division Sony Corp. 6-7-35 Kitashinagawa**
**Shinagawa-ku Tokyo 141(JP)**
Inventor: **Nakamura, Akira**
**Patents Division Sony Corp. 6-7-35 Kitashinagawa**
**Shinagawa-ku Tokyo 141(JP)**

(74) Representative: **Thomas, Christopher Hugo et al**
**D Young & Co 10 Staple Inn**
**London WC1V 7RD(GB)**

## Description

This invention relates to semiconductor laser apparatus for optical heads of optical recording/reproducing apparatus. Such semiconductor laser apparatus is used for performing beam irradiation and incident beam detection.

An optical head used in an optical recording/reproducing apparatus irradiates an optical recording medium with a beam, and detects a modulated beam from the optical recording medium, to perform information recording/reproducing.

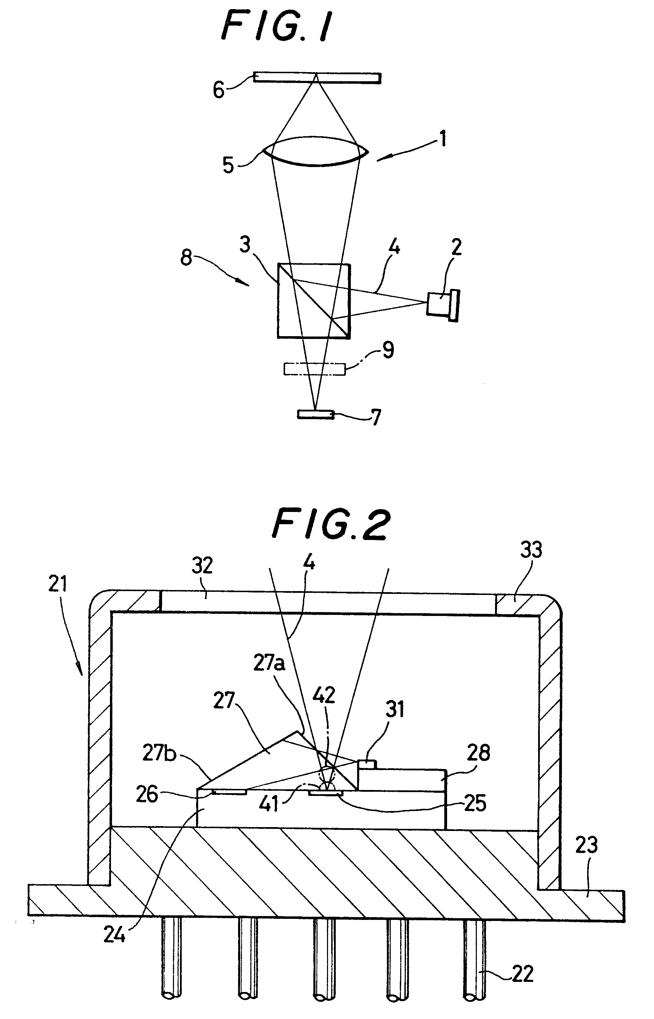

The optical head normally uses a semiconductor laser apparatus. Figure 1 to which reference is now made shows an optical head 1 using a known semiconductor laser apparatus. In the optical head 1, a beam 4 radiated from a semiconductor laser 2 and reflected by a beam splitter 3 is incident on an optical recording medium 6 through an objective lens 5. The beam 4, reflected by the optical recording medium 6 and passing through the objective lens 5 and the beam splitter 3, is incident on a photodetector 7. In the optical head 1, the semiconductor laser 2, the beam splitter 3, and the photodetector 7 form a semiconductor laser apparatus 8.

In the semiconductor laser apparatus 8, the need for positional adjustment of the three separate optical components results in a high cost for the optical head 1. In addition, the optical head 1 scans the optical recording medium 6 without contact, so focus servo control is required. An astigmatism method is normally used to detect focus error. In this case, since a cylindrical lens 9 is usually arranged between the beam splitter 3 and the photodetector 7, the above problem becomes even more severe.

European patent specification EP-A1-0 029 755 (US-A-4 334 300) discloses apparatus comprising a semiconductor laser chip for radiating a beam from a radiant surface thereof, a photodetector for detecting an incident beam and supplying a signal, and a beam splitter having a first surface inclined at a predetermined angle with respect to said radiant surface, said beam splitter being fixed on said photodetector.

European patent specification EP-A1 0 061 384 (US-A-4 482 803) discloses a semiconductor laser apparatus comprising a semiconductor laser chip for radiating a beam from a radiant surface thereof, a photodetector for detecting an incident beam and supplying a signal, and a beam splitter having a first surface inclined at a predetermined angle with respect to said radiant surface.

Japanese patent specification JP-A-56 93388 discloses semiconductor laser apparatus similar to the pre-characterizing part of claim 1.

According to the present invention there is provided a semiconductor laser apparatus for an optical head, the apparatus comprising:
a semiconductor laser chip for radiating a beam from a radiant surface thereof;
a photodetector for detecting an incident beam and supplying a signal;
said semiconductor laser chip and said photodetector being arranged on a common substrate; and
a beam splitter fixed on said photodetector and having a first surface inclined at a predetermined angle with respect to said radiant surface;
characterized in that:
there is further provided another photodetector, and said beam splitter has a second surface for directing those rays of the beam radiated from said semiconductor laser chip which are transmitted through said first surface of said beam splitter, towards said other photodetector, so that an output from said semiconductor laser chip is monitored by a signal from said other photodetector.

The invention will now be described by way of example with reference to the accompanying drawings, throughout which like parts are referred to by like references, and in which:

Figure 1 is a side view of an optical head using a known semiconductor laser apparatus;

Figure 2 is a side sectional view of a first embodiment of semiconductor laser apparatus according to the present invention;

Figure 3 is a plan view of part of the first embodiment;

Figure 4 is a side view of an optical head employing the first embodiment;

Figures 5A to 5C are plan views showing beam spots on a photodetector;

Figure 6 is a block diagram of a circuit for the optical head of Figure 4;

Figure 7 is a side sectional view of a second embodiment of semiconductor laser apparatus according to the present invention;

Figure 8 is a chart showing signals from an optical head employing the second embodiment; and

Figures 9 to 11 are respectively side sectional views of third to fifth embodiments of semiconductor laser apparatus not forming part of the invention as claimed.

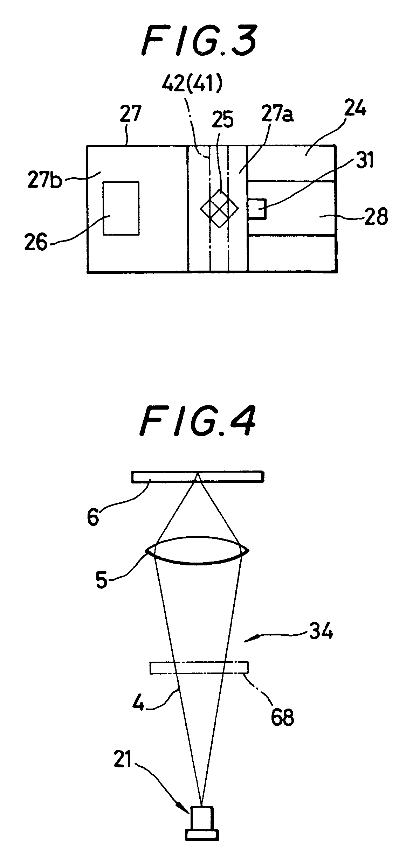

Figures 2 and 3 show the first embodiment. In a semiconductor laser apparatus 21 of the first embodiment, a silicon substrate 24 is fixed on a stem 23 with leads 22. A PIN diode 25 used as a signal detecting photodetector and a PIN diode 26 used as a laser output monitoring photodetector are formed on the silicon substrate 24.

A triangular prism 27 is fixed by an adhesive to the silicon substrate 24 to cover the PIN diodes 25 and 26. A silicon substrate 28 integrally formed with the silicon substrate 24 projects next to the triangular prism 27. A laser diode chip 31 used as a semiconductor laser is arranged at the edge of the silicon substrate 28 beside the triangular prism 27. An inclined surface 27a of the triangular prism 27 opposite the laser diode chip 31 has a reflectivity of about 50%. Another inclined surface 27b has a totally reflective coating, that is, a reflectivity of 100%.

A cap 33 with a window glass 32 is mounted on the stem 23 hermetically to seal the optical sytstem. The PIN diodes 25 and 26 and the laser diode chip 31 are connected to the leads 22 by wires (not shown).

Figure 4 shows an optical head 34 employing the semiconductor laser apparatus 21. In the optical head 34, a beam 4 radiated from the laser diode chip 31 and reflected by the inclined surface 27a of the triangular prism 27 is transmitted through the window glass 32 and an objective lens 5, and is incident on an optical recording medium 6.

The beam 4 reflected by the optical recording medium 6 and transmitted through the window glass 32 and the inclined surface 27a is incident on the PIN diode 25.

In this case, the beam 4 reflected by the optical recording medium 6 is incident on the inclined surface 27a in a converged state. There is a difference between the refractive indices of the triangular prism 27 and air. For this reason, the beam 4 is subjected to astigmatism and is incident on the PIN diode 25.

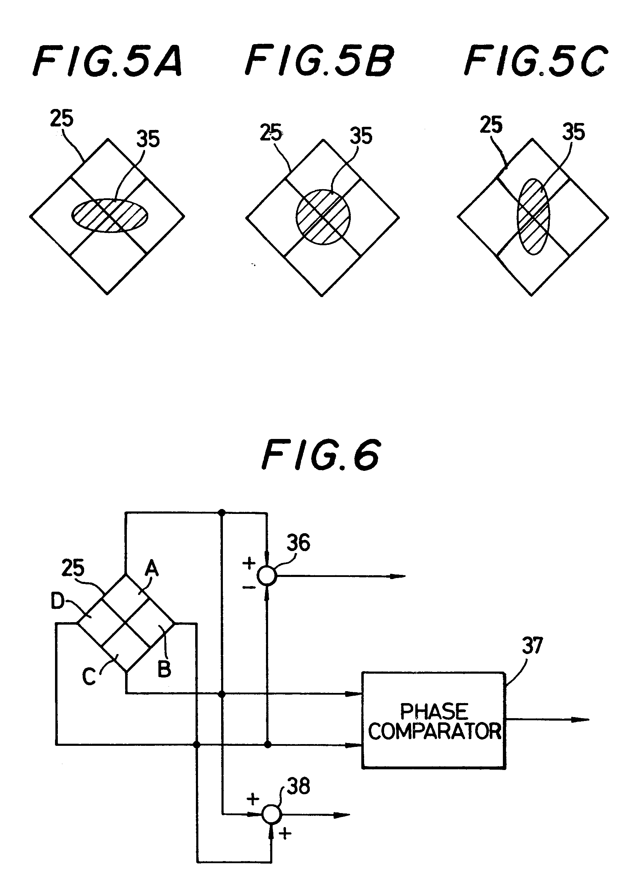

Assume that the positional relationship between the laser diode chip 31 and the PIN diode 25 is determined such that a beam spot 35 of the beam incident on the PIN diode 25 in a focused state is of the shape shown in Figure 5B. A beam spot 35 having the shape shown in Figure 5A or 5C is then formed on the PIN diode 25 in accordance with its displacement from the focused state.

As is apparent from Figure 3, the PIN diode 25 comprises four photodetecting portions A to D divided by two bisectors inclined at 45° in opposite directions with respect to the ridge of the triangular prism 27.

When a circuit in Figure 6 is used, a focus error signal (A + C) - (B + D) can be derived from a subtracter 36 which receives signals from the four photodetecting portions A to D forming the PIN diode 25, and a tracking error signal and a reproduced signal A + B + C + D can be derived from a phase comparator 37 and an adder 38, respectively.

When a sufficient astigmatic effect cannot be obtained from the refractive index difference between the triangular prism 27 and air, part of the triangular prism 27 is removed as indicated by the alternate long and short dashed lines in Figures 2 and 3 to form a cylindrical lens portion 41 or 42.

In the semiconductor laser apparatus 21 of the first embodiment, as shown in Figure 2, the beam 4 radiated from the laser diode chip 31 is transmitted through the inclined surface 27a of the triangular prism 27 and is incident on the PIN diode 26 either directly or after being reflected by the inclined surface 27b. Therefore, the output from the laser diode chip 31 can be adjusted on the basis of the output from the PIN diode 26.

In the semiconductor laser apparatus 21 of the first embodiment, the beam 4 radiated from the laser diode chip 31 and reflected by the inclined surface 27a of the triangular prism 27 does not directly return to the laser diode chip 31. For this reason, little noise is generated by the laser diode chip 31.

Furthermore, since the single triangular prism 27 serves as a beam splitter, the semiconductor laser apparatus 21 is inexpensive.

Since the PIN diodes 25 and 26 are formed on the same surface of the single silicon substrate 24, the PIN diodes 25 and 26 can be simultaneously formed by a lithographic technique.

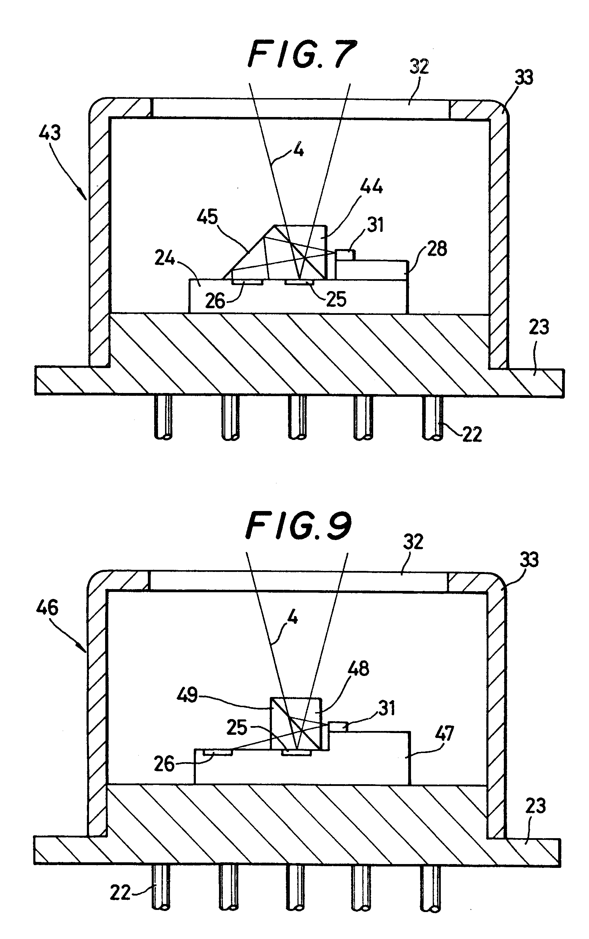

Figure 7 shows the second embodiment. A semiconductor laser apparatus 43 of the second embodiment is substantially the same as that of the first embodiment (Figure 2), except that a beam splitter is formed by two rectangular prisms 44 and 45 having different refractive indices.

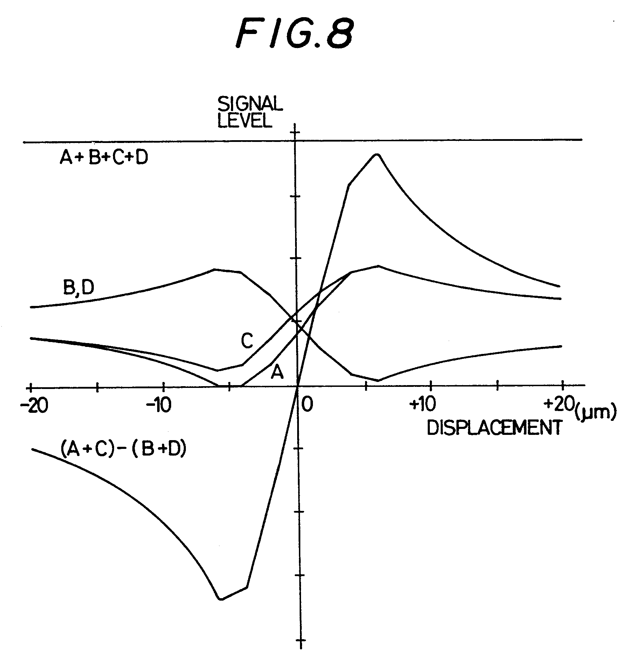

Figure 8 shows levels of signals from the PIN diode 25 when the semiconductor laser apparatus 43 of the second embodiment is used in an optical head upon displacement of an optical recording medium 6 along the optical axis of a beam 4. The rectangular prisms 44 and 45 forming a 1 mm high beam splitter are of optical glass BK7 and SF11, the NA of the objective lens 5 is 0.47, and the NA of a collimator lens (not shown in Figure 4) is 0.14.

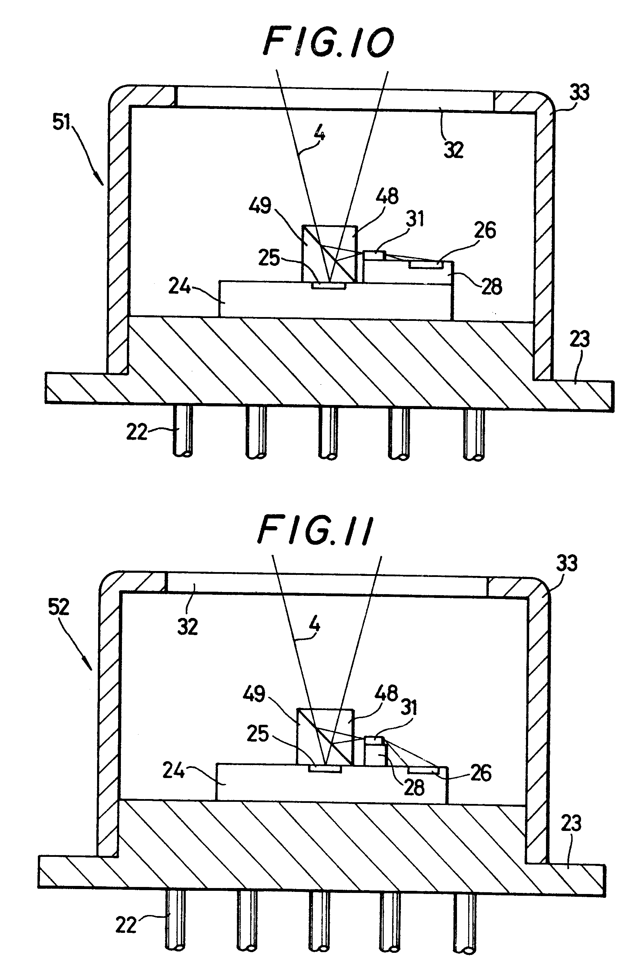

Figure 9 shows the third embodiment. A semiconductor laser apparatus 46 of the third embodiment is substantially the same as that of the first embodiment (Figure 2), except that PIN diodes 25 and 26 and a laser diode chip 31 are formed on an integral silicon substrate 47, and a beam splitter formed by two rectangular prisms 48 and 49 having refractive indices different from each other is fixed on the silicon substrate 47 at a position above only a PIN diode 25.

Figure 10 shows the fourth embodiment. A semiconductor laser apparatus 51 of the fourth embodiment is substantially the same as that of the third embodiment (Figure 9), except that a silicon substrate 28 is integrally formed with a silicon substrate 24, and a laser output monitoring PIN diode 26 is formed in the silicon substrate 28 having a laser diode chip 31 thereon.

In the semiconductor laser apparatus 51 of the fourth embodiment, the PIN diode 26 serves as a back monitor element of the laser diode chip 31.

Figure 11 shows the fifth embodiment. A semiconductor laser apparatus 52 of the fifth embodiment is substantially the same as that of the fourth embodiment (Figure 10), except that a PIN diode 26 is formed on a silicon substrate 24 having a PIN diode 25 thereon.

## Claims

1. A semiconductor laser apparatus (21) for an optical head, the apparatus (21) comprising:
   a semiconductor laser chip (31) for radiating a beam from a radiant surface thereof;
   a photodetector (25) for detecting an incident beam and supplying a signal;
   said semiconductor laser chip (31) and said photodetector (25) being arranged on a common substrate (24, 28); and
   a beam splitter (27) fixed on said photodetector (25) and having a first surface (27a) inclined at a predetermined angle with respect to said radiant surface;
   characterized in that:
   there is further provided another photodetector (26), and said beam splitter (27) has a second surface (27b) for directing those rays of the beam radiated from said semiconductor laser chip (31) which are transmitted through said first surface (27a) of said beam splitter (27), towards said other photodetector (26), so that an output from said semiconductor laser chip (31) is monitored by a signal from said other photodetector (26).

2. An apparatus (21) according to claim 1 further comprising a window (32) for receiving a beam radiated from said semiconductor laser chip (31) and reflected by said first surface (27a) of said beam splitter (27), and for receiving the beam reflected by an optical recording medium (6).

3. An apparatus (21) according to claim 2 wherein said beam splitter (27) comprises a prism (27), and said photodetector (25) comprises four photodetecting portions (A, B, C, D) divided by two bisectors inclined at 45° in directions opposite to a ridge of said beam splitter (27), two pairs of said photodetecting portions (A, B, C, D) arranged symmetrically with respect to an intersection of the two bisectors being arranged to generate outputs for deriving a focus error signal, the focus error signal being calculated as an astigmatism from a difference between a sum of the outputs from one pair of opposing photodetecting portions (A, B, C, D) and a sum of the outputs from the other pair of opposing photodetecting portions (A, B, C, D).

4. An apparatus (21) according to claim 3 wherein the total sum of the outputs from said photodetecting portions (A, B, C, D) forms a reproduced signal.

5. An apparatus (21) according to claim 3 wherein said prism (27) comprises first and second triangular prisms (44, 45) having refractive indices different from each other.

## Patentansprüche

1. Halbleiterlaservorrichtung (21) für einen optischen Kopf
   mit einem Halbleiterlaserchip (31), der eine Strahlfläche zur Aussendung eines Strahls aufweist,
   mit einem Photodetektor (25) zum Detektieren eines auftreffenden Strahls und zur Erzeugung eines entsprechenden Signals,
   wobei Halbleiterlaserchip (31) und Photodetektor (25) auf einem gemeinsamen Substrat (24, 28) angeordnet sind,
   sowie mit einem auf dem Photodetektor (25) befestigten Strahlenteiler (27) mit einer ersten Fläche (27a), die gegenüber der Strahlfläche um einen vorbestimmten Winkel geneigt ist,
   **dadurch gekennzeichnet,**
   daß ein weiterer Photodetektor (26) vorgesehen ist,
   und daß der Strahlenteiler (27) eine zweite Fläche (17b) besitzt, die diejenigen Strahlanteile des von dem Halbleiterlaserchip (31) ausgesendeten Strahls, die durch die erste Fläche (27a) des Strahlenteilers (27) verlaufen, derart zu dem weiteren Photodetektor (26) lenken, daß die Ausgangsgröße des Halbleiterlaserchips (31) von einem von dem weiteren Photodetektor (26) abgegebenen Signal überwacht wird.

2. Vorrichtung (21) nach Anspruch 1 mit einem Fenster (32) für die Aufnahme eines von dem Halbleiterlaserchip (31) ausgesendeten Strahls und an der genannten ersten Fläche (27a) des Strahlenteilers (27) reflektierten Strahls und zur Aufnahme des von einem optischen Aufzeichnungsmedium (6) reflektierten Strahls.

3. Vorrichtung (21) nach Anspruch 2, bei der der Strahlenteiler (27) ein Prisma (27) umfaßt und bei der der Photodetektor (25) vier Photodetektorbereiche (A, B, C, D) umfaßt, die durch zwei Winkelhalbierende unterteilt sind, die gegenüber der Dachkantlinie des Strahlenteilers (27) in entgegengesetzten Richtungen um 45° geneigt sind, wobei diese Photodetektorbereiche (A, B, C, D) relativ zu dem Schnittpunkt der beiden Winkelhalbierenden paarweise symmetrisch angeordnet sind, so daß sie Ausgangssignale zur Herleitung eines Fokussierungsfehlersignals liefern, das als Astigmatismus aus der Differenz zwischen der Summe der Ausgangssignale eines der Paare von einander gegenüberliegenden Photodetektorbereichen (A, B, C, D) und der Summe der Ausgangssignale des anderen Paares von einander gegenüberliegenden Photodetektorbereichen (A, B, C, D) berechnet wird.

4. Vorrichtung (21) nach Anspruch 3, bei der die Gesamtsumme der Ausgangssignale der Photodetektorbereiche (A, B, C, D) ein Wiedergabesignal bildet.

5. Vorrichtung (21) nach Anspruch (3), bei der das Prisma (27) aus einem ersten und einem zweiten Dreieckprisma (44, 45) mit unterschiedlichen Brechungsindizes besteht.

**Revendications**

1. Dispositif laser à semi-conducteur (21) pour tête optique, le dispositif (21) comprenant :
   un circuit intégré laser à semi-conducteur (31) pour émettre un faisceau à partir d'une surface rayonnante de celui-ci ;
   un photodétecteur (25) pour détecter un faisceau incident et délivrer un signal ;
   ledit circuit intégré laser à semi-conducteur (31) et ledit photodétecteur (25) étant disposé sur un substrat commun (24, 28) ; et,
   un séparateur de faisceau (27) fixé sur ledit photodétecteur (25) et comportant une première surface inclinée (27a) selon un angle prédéterminé par rapport à ladite surface rayonnante ;
   caractérisé en ce qu'il est prévu en outre un autre photodétecteur (26), et en ce que ledit séparateur de faisceau (27) possède une seconde surface (27b) pour diriger ceux des rayons du faisceau émis par ledit circuit intégré laser à semi-conducteur (31) qui sont transmis à travers ladite première surface (27a) dudit séparateur de faisceau (27), en direction dudit autre photodétecteur (26), de manière à ce que la sortie dudit circuit intégré laser à semi-conducteur (31) soit pilotée par un signal issu dudit autre photodétecteur (26).

2. Dispositif (21) selon la revendication 1 comprenant de plus une fenêtre (32) pour recevoir un faisceau émis à partir dudit circuit intégré laser à semi-conducteur (31) et réfléchi par ladite première surface (27a) dudit séparateur de faisceau (27), et pour recevoir le faisceau réfléchi par un support d'enregistrement optique (6).

3. Dispositif (21) selon la revendication 2, dans lequel ledit séparateur de faisceau (27) comprend un prisme (27), et ledit photodétecteur (25) comprend quatre parties photodétectrices (A, B, C, D) divisées par deux bissectrices inclinées à 45° dans des directions opposées à l'arrête dudit séparateur de faisceau (27), deux paires desdites parties photodétectrices (A, B, C, D), disposées de manière symétrique par rapport à l'intersection des deux bissectrices étant agencées pour produire des sorties pour obtenir un signal d'erreur de focalisation, le signal d'erreur de focalisation étant calculé comme un astigmatisme à partir de la différence entre la somme des sorties de l'une des paires de parties photodétectrices opposées (A, B, C, D) et la somme des sorties de l'autre paire de parties photodétectrices opposées (A, B, C, D).

4. Dispositif (21) selon la revendication 3, dans lequel la somme totale des sorties desdites parties photodétectrices (A, B, C, D) forme un signal reproduit.

5. Dispositif (21) selon la revendication 3, dans lequel ledit prisme (27) comprend un premier et un second prismes triangulaires (44, 45) ayant des indices de réfraction différents l'un de l'autre.

FIG. 1

FIG. 2

# F I G.3

# F I G.4

# FIG.5A  FIG.5B  FIG.5C

# FIG.6

PHASE COMPARATOR

# FIG.7

# FIG.9

# FIG.8

## FIG.IO

51 · 4 · 33 · 32 · 49 · 48 · 31 · 26 · 25 · 28 · 24 · 23 · 22

## FIG.II

52 · 33 · 32 · 4 · 49 · 48 · 31 · 25 · 26 · 24 · 28 · 23 · 22